(19)

Europäisches
Patentamt

European
Patent Office

Office européen
des brevets

(11) **EP 3 116 001 A1**

(12) **EUROPEAN PATENT APPLICATION**

(43) Date of publication:
**11.01.2017 Bulletin 2017/02**

(51) Int Cl.:
**H01F 27/42** *(2006.01)*          **G01R 15/18** *(2006.01)*

(21) Application number: **15175857.0**

(22) Date of filing: **08.07.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(71) Applicant: **Tyco Electronics UK Limited
Swindon, Wiltshire SN3 5HH (GB)**

(72) Inventor: **MC GANN, Melvyn
Chelmsford, Essex CM2 6HA (GB)**

(74) Representative: **Grünecker Patent- und
Rechtsanwälte
PartG mbB
Leopoldstraße 4
80802 München (DE)**

(54) **IMPEDANCE-COMPENSATED CURRENT TRANSFORMER**

(57)    The present invention relates to current transformers and in particular provides an impedancecompensated current transformer. According to the present invention, the current transformer comprises a secondary winding which in operation is magnetically coupled to a primary winding having a primary inductance ($L_P$), the secondary winding having a first and a second terminal, wherein a winding resistance ($R_W$) and a winding inductance ($L_S$) are present between said first and second terminals, an impedance conversion circuit (102) being electrically connected to said first terminal (120) of said secondary winding for providing an output signal to a current detection means at an output terminal (O/P), and an impedance compensation circuit (110) electrically coupled between the second terminal (122) of said secondary winding and a reference potential, wherein said impedance-compensation circuit (110) forms a negative resistance ($Z_{in}$) in series to said secondary winding.

Fig. 6

**Description**

The present invention relates to current transformers and in particular provides an impedance-compensated current transformer.

The current transformer (C.T.) is a type of instrument transformer that is designed to produce an alternating current in its secondary winding which is proportional to the current being measured in its primary winding. Current transformers provide a convenient way of safely monitoring the actual electrical current flowing in an AC transmission line using a standard current detection means. The principle of operation of a current transformer is no different from that of an ordinary transformer.

The current transformer comprises only one or very few turns as its primary winding. This primary winding can be of either a single flat turn, a coil of heavy duty wire wrapped around the core or just a conductor or bus bar placed through a central hole. Due to this type of arrangement, the current transformer is often referred to as a series transformer as the primary winding, which never has more than a very few turns, is in series with the current carrying conductor.

The secondary winding may have a large number of coil turns wound on a core of magnetic material which has a large cross-sectional area so that the magnetic flux density is low, and using much smaller cross-sectional area wire, depending upon how much the current must be stepped down.

There are three basic types of current transformers. This description applies primarily to those C.Ts that are used externally to actual measurement instruments, but, as described below, the invention could in principle be applied to these devices.

- Wound current transformers: The transformers primary winding is physically connected in series with the conductor that carries the measured current flowing in the circuit. The magnitude of the secondary current is dependent on the turns ratio of the transformer.

- Toroidal current transformers: These do not contain a primary winding. Instead, the line that carries the current flowing in the network is threaded through a window or hole in the toroidal transformer. Some current transformers have a "split core" which allows it to be opened, installed, and closed, without disconnecting the circuit to which they are attached.

- Bar-type current transformers: This type of current transformer uses the actual cable or bus-bar of the main circuit as the primary winding, which is equivalent to a single turn. They are fully insulated from the high operating voltage of the system and are usually bolted to the current carrying device.

External Current Transformers can reduce or "step-down" current levels from thousands of amperes down to a standard output of a known ratio. C.Ts for use external to measuring instruments generally have secondary windings rated as standard to either 5 A or 1 A for normal operation. Thus, small and accurate instruments and control devices can be used with C.T.'s because they are insulated away from any high-voltage power lines. There are a variety of metering applications and uses for current transformers such as with Wattmeters, power factor meters, watt-hour meters, protective relays, or as trip coils in magnetic circuit breakers, or miniature circuits breakers (MCB). Generally, current transformers and ammeters are used together as a matched pair in which the design of the current transformer is such as to provide a maximum secondary current corresponding to a full-scale deflection on the ammeter. In most current transformers an approximate inverse turns ratio exists between the two currents in the primary and secondary windings.

Most external current transformers have a standard secondary rating of e.g. 5 A with the primary and secondary currents being expressed as a ratio such as 100/5. This means that the primary current is 20 times greater than the secondary current, so when 100 A is flowing in the primary conductor it will result in 5 A flowing in the secondary winding. Similarly, a C.T. described as 500/5 will produce 5 A in the secondary for 500 A in the primary conductor, etc.

By increasing the number of turns in the secondary winding, the secondary current can be made much smaller than the current in the primary circuit being measured because as the number of secondary windings increases, the current goes down by a proportional amount. In other words, the number of turns and the current in the primary and secondary windings are related by an inverse proportion.

The present invention derives from and relates to the use of current transformers in low-power precision measurement applications, generally but not exclusively fitted within a measuring instrument. However, the principles described could be applied to transformers used in medium power applications to improve their performance in terms of accuracy, size and cost. It is primarily concerned with devices that operate at power network frequencies, for example 50Hz, 60Hz and 400Hz.

As already mentioned above, current transformers are widely used for sensing AC currents in a conductor for providing an isolated signal that is linearly related to the current flowing in the conductor. This, for conventional current transformers, is achieved by coupling the alternating magnetic field produced by the current being measured through a secondary coil that provides an output. The arrangement often uses a magnetic material that concentrates the magnetic field and mechanically supports the coil structure. Examples include the well-known E and I arrangement, or toroidal forms where the current being measured may flow in a large conductor that passes just once through the centre of the toroid. In this case, the toroid may be split so that it can be easily fitted to, or removed from, the conductor whose current is being measured.

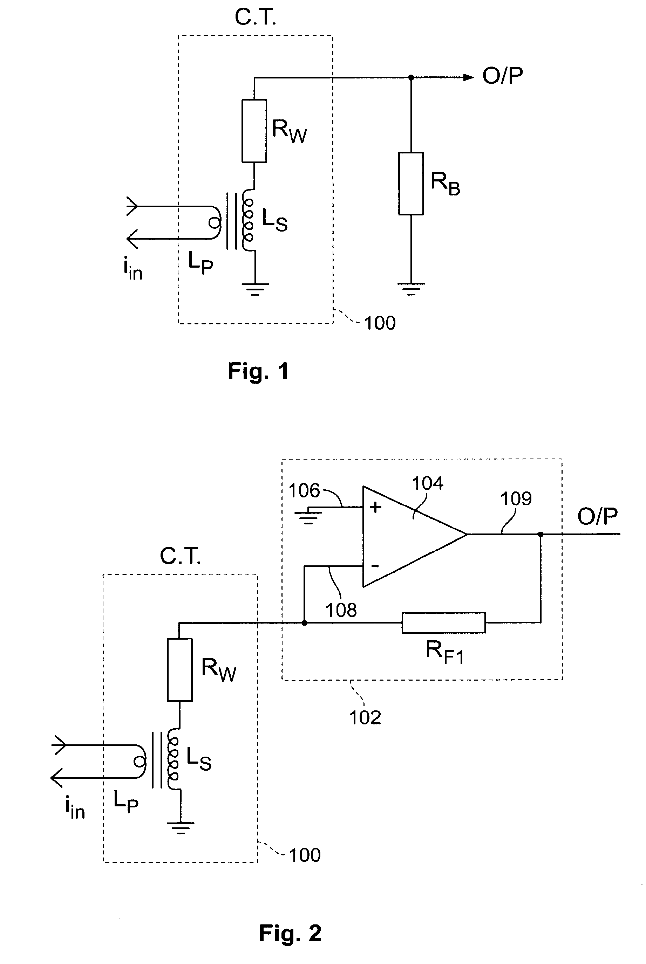

As the C.T. device is passive, the output will be a signal having the same frequency and (ideally) wave shape to the current being measured. The conventional arrangement is shown in Fig. 1, where $R_W$ is the winding resistance, $R_B$ is the burden resistor, and $L_S$ is the secondary winding inductance. $L_P$ is the primary inductance.

In most standard applications, the secondary winding of the transformer will be loaded with a burden resistance that produces the voltage used for measurement purposes. Also, the secondary winding will itself have a resistance, and the power transmitted through the device will be determined by the sum of these two resistances. Clearly, this can never be zero. (There could in theory be a contribution from the transformed impedance from the primary circuit, but as most C.T.s have a very large effective turns ratio, this is normally insignificant.)

Clearly, the degree of precision required will depend on the application, but shortcomings in accuracy can be caused by various deficiencies such as e. g. the following:

1. Not all the magnetic field from the primary side is coupled to the secondary side.

2. The magnetic coupling may be nonlinear due to dynamic shortcomings in the magnetic properties of the coupling medium, i.e. the transformer core.

3. Improper loading of the secondary coil causes the output current to be an inaccurate representation of the primary current. The load resistance connected to the secondary, commonly known as the "burden", together with the winding resistance, creates a low-frequency time constant with the inductance of the secondary winding. This time constant $\tau$ will basically be:

$$\tau = \frac{L_S + \frac{1}{n^2}L_P}{R_B + R_W} \tag{1}$$

wherein n is the effective turns ratio. For the output to correctly represent the input, this must represent a frequency far below that being measured, so that too high a value of burden resistor or too low an inductance in the C.T. secondary will degrade the accuracy.

4. Magnetic coupling may vary depending on the frequency of the current being measured.

5. DC components in the primary current, or DC currents in the secondary that are unrelated to the measurement, can adversely affect magnetic properties of the core material, leading to nonlinearity.

Clearly, coupling from the primary side to the secondary side can never be a perfect 100%. However, in order to couple as much of the magnetic field from the primary to secondary as possible, it is necessary to either arrange the mechanical construction to provide the close coupling, or where this is not possible (such as in toroidal structures where the primary conductor can move within the toroid), to use a magnetic material having properties that concentrate the available field as much as possible in the secondary winding. In practice, this means a material having the highest possible magnetic permeability. Even in non-toroidal structures, it is generally desirable to use a magnetic material having these properties to achieve best results. This is the reason for the common use of mu-metal and similar materials for transformer laminations and for the cores in toroidal devices. A recent development in this respect are the so-called nanocrystalline magnetic materials, which are used to produce C.T. cores having an extremely high permeability.

In regard to the nonlinear behaviour, this is usually of greatest importance in precision measurement applications, where even a small distortion of the output waveform can lead to measurement inaccuracy. To achieve the least unwanted effects due to the nonlinear properties of the core material, it is important that the power conveyed through the transformer must be kept to a minimum. Then, the variations of the magnetic flux in the core will also be kept to a minimum and so the effects of non-linearity of permeability relative to the flux density will be minimised.

The secondary winding will have a number of turns that is determined by the primary current to be measured and by the requirements of the subsequent measurement circuit. For a given application, this will require a fairly narrow range of values for the effective turns ratio n. This leaves little scope for power reduction. The only way to obtain the desired result may be to use a thicker wire for the secondary to reduce the winding resistance, to use the largest acceptable core size, and to use the lowest acceptable value of burden resistance.

Moreover, some conventional C.T. devices use an impedance compensation for operating the sensor device at reduced magnetizing inductance levels. Examples of such impedance-compensated current transformers are disclosed in US 2014/0159704 A1 and US 7,525,297 B2. These known systems, however, are firstly rather complex e. g. by involving additional signals and circuitry, and secondly have the disadvantage that their stability against oscillations and DC latch-up effects are unsatisfactory.

The object underlying the present invention is to overcome the drawbacks of the existing solutions and to provide a current transformer that allows measuring AC currents with an improved linearity and reduced noise by means of an economic and robust device.

This object is solved by the subject matter of the independent claims. Advantageous embodiments of the present invention are the subject matter of the dependent claims.

According to the present invention, an impedance-compensated current transformer is provided which has a secondary winding which in operation is magnetically coupled to a primary winding having a primary inductance, the secondary winding having a first and a second terminal, wherein a winding resistance and a winding inductance are present between said first and second terminals.

An impedance conversion circuit is electrically connected to said first terminal of said secondary winding for providing an output signal to a current detection means at an output terminal. Furthermore, an impedance compensation circuit is electrically coupled between the second terminal of said secondary winding and a reference potential, wherein said impedance-compensation circuit forms a negative resistance in series to said secondary winding.

The present invention is based on the finding that for precision applications or where space and cost must be limited, means of impedance conversion and compensation using active circuitry can be employed. Firstly, the burden resistance can be eliminated by feeding the C.T. secondary into the virtual-earth input of an op-amp. This can give a significant reduction in the power throughput of the C.T., and also allows any desired output voltage to be obtained, depending on the op-amp feedback arrangement. For example, the value of a feedback resistor sets the output voltage, and the C.T. secondary always sees an impedance very close to zero.

By using negative resistance compensation, the adverse effects of the actual winding resistance can be compensated. In effect, a negative resistor can be connected in series with the C.T. winding so that the winding resistance is cancelled out. In theory, it is possible to perfectly eliminate the winding resistance, but this requires very accurate component and winding tolerances, and in practice, reductions up to 95% can easily be achieved and are all that is necessary. As the arrangement makes use of positive feedback, there is a danger for instability to occur, which is why perfect compensation preferably is not used according to the present invention.

As the negative resistance approaches the value of the real resistance within the circuit, a progressive reduction of power transfer and increase in circuit time-constant is produced, so that linearity and low-frequency response will progressively improve. This allows a compromise to be chosen between convenience, cost, and performance, depending on the application.

The current transformer according to the present invention comprises two op-amps, but allows convenient setting of parameters. The C.T. secondary side behaves as a current source, so that there is no significant interaction between the two sides of the circuit. Here, the output level can be set by varying the first feedback resistance, whereas the negative resistance compensation can be independently configured by varying either the first resistor or the second feedback resistance.

According to the present invention, the output signal is extracted from one end of the C.T. secondary winding using a virtual-earth amplifier, whereas the opposite end of the secondary winding is connected to the impedance compensation circuit. This avoids level changes that can occur if the winding resistance changes due to temperature etc. It also avoids the need for precision matching of the resistors that are used. According to an advantageous embodiment of the present invention, the impedance conversion circuit comprises a first operational amplifier, wherein said first operational amplifier comprises a positive input terminal, a negative input terminal, and an output terminal, wherein said negative terminal of the first operational amplifier is connected to the secondary winding and to the output terminal via a first feedback resistor.

The present invention is further based on the idea that detrimental oscillations can be avoided by providing an imperfect matching, such that the negative resistance never exceeds the positive (real) resistance in the circuit. Accordingly, said negative resistance may have an absolute value that is equal to or smaller than said winding resistance.

There are various ways of synthesizing a negative resistor using operational amplifiers (which are also called op-amps in the following description).

According to an embodiment of the present invention, said first impedance compensation circuit comprises a second operational amplifier, wherein said second operational amplifier comprises a positive input terminal, a negative input terminal, and an output terminal, wherein said negative terminal of the first operational amplifier is connected to the secondary winding and to the output terminal via a second feedback resistor. The impedance compensation circuit further comprises a first resistor and a second resistor, wherein said positive input terminal of the second operational amplifier is connected to said reference potential via a first resistor and wherein said output terminal is further connected to said positive terminal via a second resistor.

The input impedance of such a circuit arrangement is given by equation (2).

$$Z_{in} = \frac{-R_{F2} \cdot R_1}{R_2} \qquad (2)$$

In equation (2), $Z_{in}$ is the input impedance, $R_{F2}$ is the feedback resistance of the impedance compensation circuit, $R_1$ is the first resistor, and $R_2$ is the second resistor.

According to a further advantageous embodiment, a value of said second resistor is chosen to be larger than a ratio of the product of said feedback resistor and said first resistor to said winding resistance. This relation is expressed by the following inequation (3).

$$R_2 > \frac{R_{F2} \cdot R_1}{R_W} \qquad (3)$$

Here, $R_W$ signifies the winding resistance. For perfect impedance matching, the AC voltage across the secondary winding inductance will be zero for any input current, signifying a power throughput in the C.T. of zero, and so giving perfect linearity. In the limiting cases, a value of $R_1 = 0$, or $R_2 =$ open circuit, would clearly give zero compensation.

Of course, this assumes a perfect op-amp, and in practice, distortion from this source may need to be taken into account. As stated previously, in practice the degree of positive feedback will always be set slightly less than this value, that is, the value of the second resistor $R_2$ will always be set slightly higher than indicated, ensuring stability. Nevertheless, it could be shown that optimal compensation results can be obtained.

A further benefit of the inventive arrangement is that it has the effect of increasing the time-constant formed by the secondary inductance and the circuit resistances. This is equivalent to the inductance value of the secondary winding (measured out of circuit) being magnified by an amount that depends on the degree of compensation. Therefore, for operation at a given frequency, it is possible to use a transformer core that either has a lower permeability or a smaller size (or both) than would otherwise be required. A further advantage of this is that lower-permeability materials are likely to have a better high-frequency response. This means that harmonic response of the overall system will be improved. It is well-known that ferrite materials in general have a much better frequency response than nanocrystalline materials.

According to a further advantageous embodiment, the first impedance-correction circuit further comprises a first capacitor which is serially connected between said output terminal and said second resistor. This arrangement has the advantage that the occurrence of DC latch-up of the operational amplifier can be prevented.

The following equation (4) gives the input impedance of an impedance-correction circuit with an additional series capacitor having a capacity C according to this embodiment:

$$Z_{in} = \frac{-j\omega C R_{F2} \cdot R_1}{1 + j\omega C R_2} \qquad (4)$$

Provided C is chosen to be large enough, the impedance $Z_{in}$ is close to the value given in equation (2).

Furthermore, if the C.T. arrangement is to be used over a wide temperature range, it may be necessary to allow for the resistance changes in the secondary winding due to temperature by adding a resistance-equalising circuit in series with the secondary winding. This can be for instance easily achieved using a negative temperature coefficient (NTC) thermistor of suitable characteristics. As this is known in the art, NTC thermistors are thermally sensitive resistors made from e. g. a mixture of Mn, Ni, Co, Cu, Fe oxides. Sintered ceramic bodies of various sizes can be obtained. This semi-conducting material reacts as an NTC resistor, whose resistance decreases with increasing temperature. This negative temperature coefficient effect can result from an external change of the ambient temperature or an internal heating due to the Joule effect of a current flowing through the thermistor. By varying the composition and the size of the thermistors, a wide range of resistance values ($0.1\Omega$ to $1M\Omega$) and temperature coefficients (-2 to -6% per K) can be achieved.

Advantageously, the present invention is used with input currents at a power network frequency of 50 Hz, 60 Hz, or 400 Hz.

As mentioned above, the primary winding may advantageously be a part of the current transformer. In this case, the primary winding is serially connected with a conductor carrying the current to be measured. However, the present invention is intended to be used with any design of current transformer.

The present invention further relates to a method of operating a current transformer. The method comprises magnetically coupling a secondary winding of said current transformer to a primary winding having a primary inductance, the secondary winding having a first and a second terminal, wherein a winding resistance and a winding inductance are present between said first and second terminals. According to the present invention, the method further comprises compensating an impedance of said secondary winding by means of an impedance compensation circuit which is electrically coupled in series to said secondary winding and operates as a negative resistance in a way that a power conveyed through said current transformer is minimal.

The present invention is based on the finding, that by compensating the impedance of the secondary winding by means of a negative impedance, the power conveyed through the transformer can be kept to a minimum. Thereby, the variations of the magnetic flux in the core will also be kept to a minimum and thus the effect of non-linearity of permeability relative to the flux density will be minimized. The accuracy of the measurement results can be improved significantly. It could be shown that comparatively simple circuit arrangements are suitable for achieving this result. In particular, no perfect impedance matching is necessary.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:

**FIG. 1**    shows a conventional current transformer with a burden resistor;

**FIG. 2**    is a schematic representation of a current transformer with an impedance conversion circuit;

**FIG. 3**    is a schematic representation of a circuit forming a negative impedance;

**FIG. 4**    is a schematic representation of a further circuit forming a negative impedance;

**FIG. 5**    is a schematic representation of a current transformer with a negative impedance according to Fig. 3;

**FIG. 6**    is a schematic representation of a current transformer according to a first embodiment of the present invention;

**FIG. 7**    is a schematic representation of a current transformer according to a second embodiment of the present invention;

**FIG. 8**    is a schematic representation of a current transformer having temperature compensation means.

The present invention will now be further explained referring to the Figures, and firstly referring to Figure 2. Figure 2 shows a schematic representation of a current transformer 100 with an impedance conversion circuit 102.

In the arrangement shown in Fig. 2, the current transformer 100 comprises a primary winding $L_P$ and a secondary winding represented by its winding inductance $L_S$ and the winding resistance $R_W$. However, as set forth above, there are also current transformers which do not comprise a primary winding, but only a secondary winding, the primary winding being formed by the wire carrying the current $i_{in}$ to be measured. The present invention is of course intended to be used with all forms of current transformers.

The current transformer 100 is connected to an impedance conversion circuit 102 which provides an output signal O/P to an external current detection means (not shown in the Figures). The impedance conversion circuit comprises a first operational amplifier 104 with a positive input terminal 106, a negative input terminal 108, and an output terminal 109. The impedance conversion circuit 102 essentially is an amplifier with low input and output impedances. Its function is to eliminate the burden resistance $R_B$ of Fig. 1. Providing such an impedance conversion circuit 102 allows for a reduction of the power throughput of the C.T. 100, and also allows any desired output voltage to be obtained, depending on the op-amp feedback arrangement. Consequently, this impedance conversion circuit 102 has the function of a current to voltage converter. As shown in Fig. 2, the value of the feedback resistor $R_{F1}$ sets the output voltage and the C.T. secondary winding always sees an impedance very close to zero.

According to the present invention, a negative resistance compensation is used to reduce the effects of the actual winding resistance as far as possible. In particular, the power which is conveyed through the transformer 100 is kept to a minimum thereby.

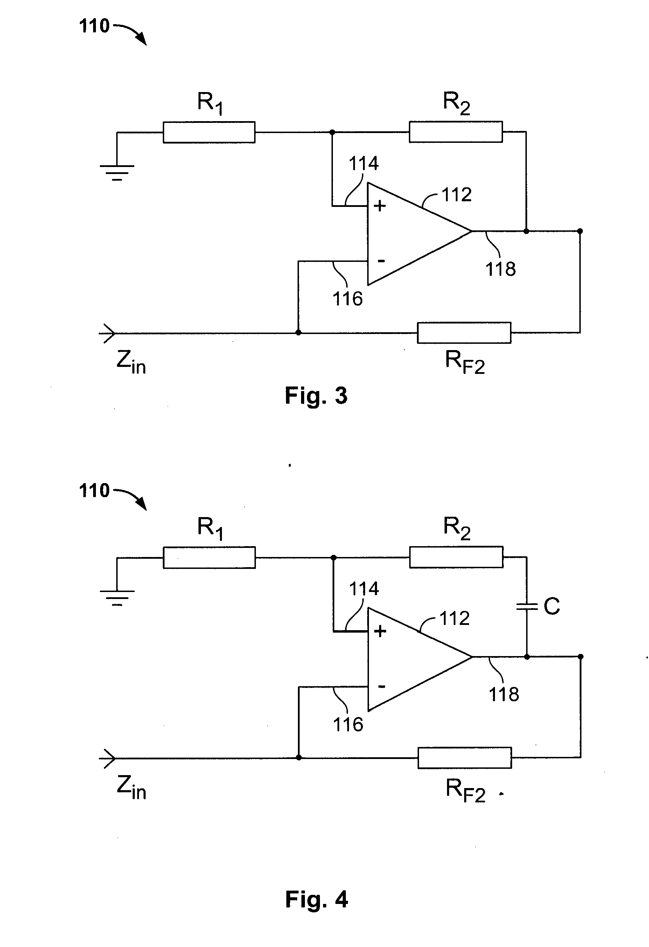

There are various ways of synthesizing a negative resistor. Exemplarily, circuitry based on op-amps can be used for forming the negative impedance. With reference to Fig. 3, a particularly simple and effective impedance compensation circuit 110 will be explained in the following. This impedance compensation circuit 110 comprises an operational amplifier 112 with a positive input terminal 114, and a negative input terminal 116 and an output terminal 118. The output terminal 118 is connected to the negative input terminal 116 via a feedback resistor $R_{F2}$. The first resistor $R_1$ is provided for connecting the positive input terminal 114 with a reference potential, for instance ground. A second resistor $R_2$ connects the output terminal 118 with the positive input terminal 114. The input impedance $Z_{in}$ of this circuit can be calculated using equation (2) given above.

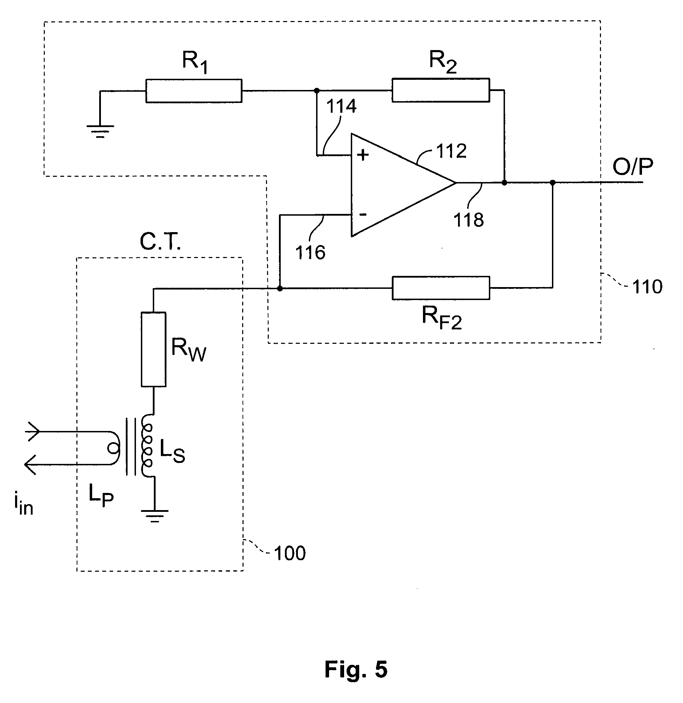

By suitably choosing the values for the first and second resistors and the feedback resistor, a value matching the secondary winding resistance can be generated. The negative resistance can be connected in series with the positive resistance $R_W$ of the secondary winding as this is shown in Fig. 5. In this arrangement for a perfect matching the following equation (5) is valid:

$$\frac{R_2}{R_1} = \frac{R_{F2}}{R_W} \qquad\qquad (5)$$

Under these conditions, the AC voltage across the winding inductance $L_S$ will be zero for any input current, signifying a power throughput of the C.T. of zero, and so giving perfect linearity. Of course, this assumes that the operational amplifier 112 is ideal and in practice distortion from this source may have to be taken into account.

As already mentioned above, a perfect matching in order to completely eliminate the winding resistance is not easily achieved and requires accurate component and winding tolerances. Due to the fact that the impedance compensation circuit 110 uses a positive feedback of the operational amplifier 112, it is possible for instability to occur. Consequently, not a perfect compensation is used, but the input impedance $Z_{in}$ is chosen to be slightly lower in its absolute value than the winding resistance. In particular, in order to produce the degree of positive feedback of the operational amplifier 112, the value for the resistor $R_2$ can be set to be slightly higher than given by equation (5), thus ensuring stability.

Fig. 4 shows a further advantageous embodiment of an impedance compensation circuit 110 that can be used with the current transformer 100 according to the present invention. The circuit 110 is the same as shown in Fig. 3, with the exception that a capacitor C is provided in series to the second resistor $R_2$. This improved impedance compensation circuit 110 has the advantage that a DC latch-up of the operational amplifier 112 can no longer occur. As already mentioned above, the impedance of the circuit shown in Fig. 4 is calculated using equation (4). Is the value for the capacitance C is chosen large enough, the input resistance $Z_{in}$ is approximately the same as given by equation (2).

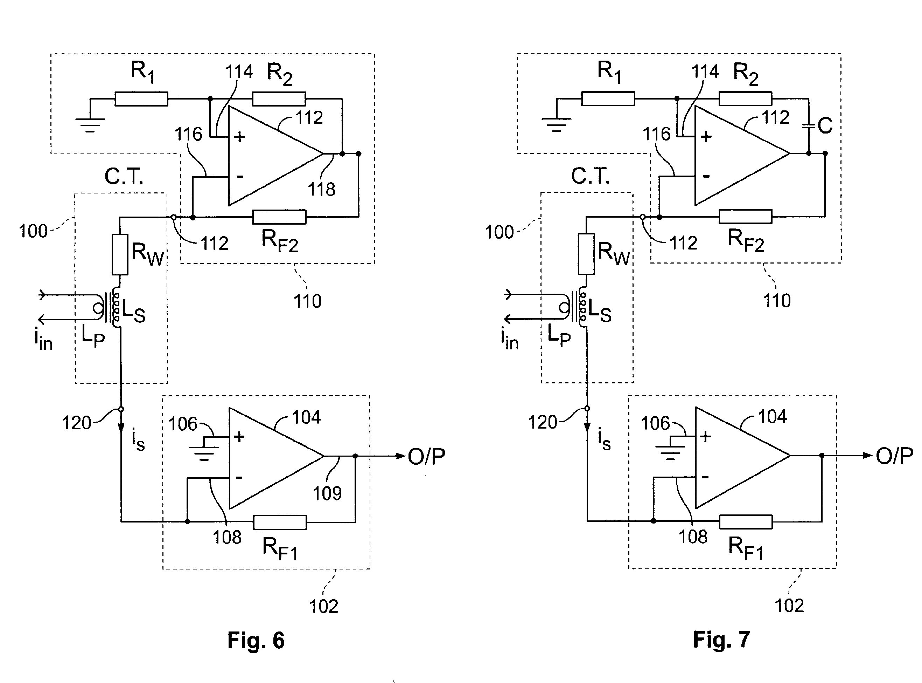

Fig. 6 shows an advantageous embodiment of the present invention using an impedance conversion circuit 102 arranged at a first terminal 120 of the secondary winding and an impedance compensation circuit 110 connected to the opposing terminal 122 of the secondary winding. The impedance conversion circuit 102 and the impedance compensation circuit 110 have the characteristics explained above with reference to Figures 2 to 4.

Advantageously, the output signal O/P is extracted via the impedance conversion circuit 102 from the end of the C.T. secondary winding which is opposite to the terminal connected to the impedance compensation circuit 110. By using a virtual-earth amplifier 104, level changes that can occur if the winding resistance $R_W$ changes due to temperature effects or the like can be avoided. Thus, the output signal O/P to an external current detection means will be independent of the operation of the impedance compensation circuit 110. As already mentioned above, any other circuit forming a negative impedance may also be used as the impedance compensation circuit 110 in Fig. 6.

In the arrangement shown in Fig. 6, the C.T. secondary side behaves as a current source, so that there is no significant interaction between the impedance conversion circuit 102 and the impedance compensation circuit 110. The output level can be set by varying the value of the feedback resistor $R_{F1}$, whereas the negative resistance compensation can be independently configured by varying either the value of the feedback resistor $R_{F2}$ or the second resistor $R_2$.

A further advantage of using a negative resistance for impedance compensation can be seen in the fact that the time constant $\tau$ formed by the secondary inductance and the circuit resistances is increased. This is equivalent to the inductance value $L_S$, which is measured out of the circuit, being magnified by an amount depends on the degree of compensation. Therefore, for operation at a given frequency, it is possible to use a transformer core that either has a lower permeability or a smaller size, or both, than would otherwise be required. Another advantage of this is that lower-permeability materials are likely to have better high-frequency response. This means that harmonic response of the overall system will be improved.

It is well known in the art that ferrite materials in general have a much better frequency response than nanocrystalline materials. Referring to Figures 6 and 1, it can be shown that the increase in the effective time constant $\tau$ due to the compensation can be calculated by the following equation (6).

$$\frac{Improved\ \tau}{Conventional\ \tau} = \frac{(R_W + R_B) \cdot R_2}{R_2 \cdot (R_W + R_3) - R_1 \cdot R_{F2}} \tag{6}$$

Here, the resistor $R_3$ is any external resistor that may be added in series with the secondary winding, for instance a thermal compensating device. The remaining parameters have their meanings as given above.

As already mentioned above with reference to Fig. 4, a DC latch-up of the impedance compensation circuit 110 can be avoided by adding a capacitor C as shown in Fig. 7. By choosing the value C large enough, the circuit arrangement shown in Fig. 7 has the same impedance correction characteristics as the one shown in Fig. 6.

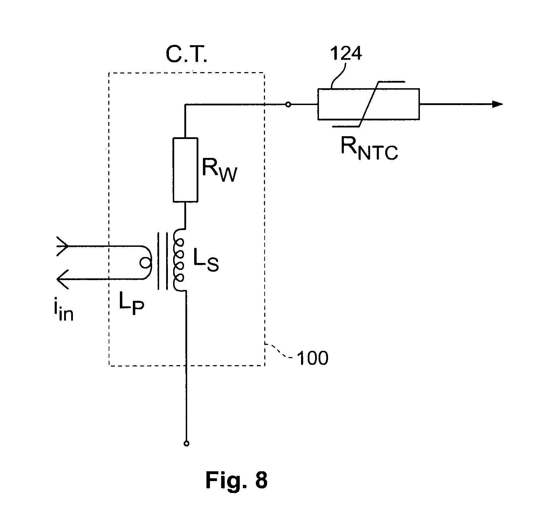

Moreover, the current transformer according to the present invention normally will be used over a wide temperature range. Advantageously, temperature compensating means 124 can be added in series with the secondary winding of the C.T. 100. Fig. 8 shows an advantageous embodiment of a negative temperature coefficient resistor being used as the temperature compensating means 124. As already mentioned above, such an NTC thermistor provides resistance equalizing functionality by having a resistance value that decreases with increasing temperature. However, of course also any other temperature compensating means can also be employed according to the present invention.

In principle, the arrangements described above could also be used in higher-power applications where precision is less important than the apparent increase in secondary inductance that is produced. In that case, the op-amp used might need to be a high-power device, or even a power amplifier, but the operating principle remains unchanged. This could be used in applications where mechanical constraints make it difficult to construct a C.T. that has enough inductance for use in the conventional circuit, for example detachable C.T.s for portable applications.

### REFERENCE NUMERALS

| Reference Numeral | Description |
| --- | --- |
| 100, C.T. | Current transformer |
| 102 | Impedance conversion circuit |
| 104 | First operational amplifier |
| 106 | Positive input terminal of the first operational amplifier |
| 108 | Negative input terminal of the first operational amplifier |
| 109 | Output terminal of the first operational amplifier |
| 110 | Impedance compensation circuit |
| 112 | Second operational amplifier |
| 114 | Positive input terminal of the second operational amplifier |
| 116 | Negative input terminal of the second operational amplifier |
| 118 | Output terminal of the second operational amplifier |
| 120 | First terminal of the secondary winding |
| 122 | Second terminal of the secondary winding |
| 124 | Temperature compensating means |
| $L_P$ | Primary inductance |
| $L_S$ | Secondary inductance |
| $i_{in}$ | Input current to be measured |
| $i_s$ | Secondary sided current |
| $R_W$ | Winding resistance |
| O/P | Output signal |
| $R_{F1}$ | First feedback resistance |
| $R_{F2}$ | Second feedback resistance |
| $R_1$ | First resistor |

(continued)

| Reference Numeral | Description |
|---|---|
| $R_2$ | Second resistor |
| C | Capacitor |
| $R_{NTC}$ | Negative temperature coefficient thermistor |

**Claims**

1. Current transformer comprising:

   a secondary winding which in operation is magnetically coupled to a primary winding having a primary inductance ($L_P$), the secondary winding having a first and a second terminal, wherein a winding resistance ($R_W$) and a winding inductance ($L_S$) are present between said first and second terminals,
   an impedance conversion circuit (102) being electrically connected to said first terminal (120) of said secondary winding for providing an output signal to a current detection means at an output terminal (O/P), and
   an impedance compensation circuit (110) electrically coupled between the second terminal (122) of said secondary winding and a reference potential, wherein said impedance-compensation circuit (110) forms a negative resistance ($Z_{in}$) in series to said secondary winding.

2. Current transformer according to claim 1, wherein said negative resistance ($Z_{in}$) has an absolute value that is equal to or larger than said winding resistance ($R_W$).

3. Current transformer according to claim 1 or 2, wherein said impedance conversion circuit (102) comprises a first operational amplifier (104) comprising a positive input terminal (106), a negative input terminal (108), and an output terminal (109), wherein said negative terminal of the first operational amplifier is connected to the secondary winding and to the output terminal via a first feedback resistor ($R_{F1}$).

4. Current transformer according to one of the preceding claims, said impedance compensation circuit (110) comprising:

   a second operational amplifier (112), wherein said second operational amplifier comprises a positive input terminal (114), a negative input terminal (116), and an output terminal (118), wherein said negative terminal of the first operational amplifier is connected to the secondary winding and to the output terminal via a second feedback resistor ($R_{F2}$),
   a first resistor ($R_1$) and a second resistor ($R_2$), wherein said positive input terminal of the second operational amplifier (112) is connected to said reference potential via a first resistor ($R_1$) and wherein said output terminal is further connected to said positive terminal via a second resistor ($R_2$).

5. Current transformer according to claim 4, said impedance compensation circuit (110) further comprising a capacitor (C) which is serially connected between said output terminal and said second resistor ($R_2$).

6. Current transformer according to claim 4 or 5, wherein a value of said second resistor ($R_2$) is chosen to be larger than a ratio of the product of said feedback resistor ($R_{F2}$) and said first resistor ($R_1$) to said winding resistance ($R_W$).

7. Current transformer according to one of the preceding claims, further comprising a temperature compensating circuit (124) which is connected in series to the first and/or second terminal of the secondary winding.

8. Current transformer according to claim 7, wherein said temperature compensating circuit comprises at least one negative temperature coefficient thermistor ($R_{NTC}$).

9. Current transformer according to one of the preceding claims, wherein said current transformer is configured to operate with input currents ($i_{in}$) at a power network frequency of 50 Hz, 60 Hz, or 400 Hz.

10. Current transformer according to one of the preceding claims, further comprising said primary winding, wherein said primary winding is serially connected with a conductor carrying the current to be measured.

11. Method of operating a current transformer, said method comprising:

   magnetically coupling a secondary winding of said current transformer to a primary winding having a primary inductance ($L_P$), the secondary winding having a first (120) and a second (122) terminal, wherein a winding resistance ($R_W$) and a winding inductance ($L_S$) are present between said first and second terminals, compensating an impedance of said secondary winding by means of an impedance compensation circuit (110) which is electrically coupled in series to said secondary winding and operates as a negative resistance ($Z_{in}$) in a way that a power conveyed through said current transformer (100) is minimal.

12. Method according to claim 11, wherein said negative resistance ($Z_{in}$) is generated to have an absolute value that is equal to or larger than said winding resistance ($R_W$).

13. Method according to claim 11 or 12, wherein an output signal is extracted from said first terminal of the secondary winding using a virtual-earth amplifier.

14. Method according to one of the claims 11 to 13, wherein said negative resistance is generated by means of an operational amplifier (112).

15. Method according to claim 14, further comprising filtering a feedback signal of said operational amplifier by means of a capacitor (C) for preventing a DC latch-up.

C.T.

**Fig. 1**

C.T.

**Fig. 2**

**110**

**Fig. 3**

**110**

**Fig. 4**

**Fig. 5**

Fig. 7

Fig. 6

**Fig. 8**

Europäisches
Patentamt

European
Patent Office

Office européen
des brevets

# EUROPEAN SEARCH REPORT

**Application Number**

EP 15 17 5857

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 42 43 130 A1 (ROHDE & SCHWARZ [DE]) 23 June 1994 (1994-06-23) | 1-6,9-15 | INV. H01F27/42 G01R15/18 |
| Y | * the whole document * & "DER NIC (NEGATIVE IMPEDANCE CONVERTER) ED - TIETZE U; SCHENK CH", 1 January 1980 (1980-01-01), HALBLEITER-SCHALTUNGSTECHNIK, BERLIN, SPRINGER-VERLAG, DE, PAGE(S) 255 - 258, XP001025862, ----- | 7,8 | |
| Y | US 2014/285180 A1 (FOOTE GARRITT W [US]) 25 September 2014 (2014-09-25) * abstract * * page 1, paragraph 5 * * page 2, paragraph 10-13 * * page 6, paragraphs 53,54 * * figures 7,8,9,10,16 * * page 4, paragraph 43 - page 5 * ----- | 7,8 | |

**TECHNICAL FIELDS SEARCHED (IPC)**

H01F
G01R

The present search report has been drawn up for all claims

| Place of search | Date of completion of the search | Examiner |
|---|---|---|
| Munich | 14 January 2016 | Kardinal, Ingrid |

## ANNEX TO THE EUROPEAN SEARCH REPORT
## ON EUROPEAN PATENT APPLICATION NO.

EP 15 17 5857

This annex lists the patent family members relating to the patent documents cited in the above-mentioned European search report.
The members are as contained in the European Patent Office EDP file on
The European Patent Office is in no way liable for these particulars which are merely given for the purpose of information.

14-01-2016

| Patent document cited in search report | | Publication date | Patent family member(s) | Publication date |
|---|---|---|---|---|
| DE 4243130 | A1 | 23-06-1994 | NONE | |
| US 2014285180 | A1 | 25-09-2014 | NONE | |

EPO FORM P0459

For more details about this annex : see Official Journal of the European Patent Office, No. 12/82

**EP 3 116 001 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140159704 A1
- US 7525297 B2